# EUROPEAN PATENT APPLICATION

(11) **EP 4 461 405 A1**
(43) Date of publication of application: **13.11.2024**
(21) Application number: 23737459.0
(22) Date of filing: 07.01.2023
(51) Int. Cl.: B01L 3/00, F16K 31/00

(54) **TARGET MATERIAL SEPARATION CONTROL DEVICE USING LASER DIODE**

(30) Priority: 07.01.2022 KR 20220002466; 04.01.2023 KR 20230001116
(71) Applicant: CTCells, Inc., Daegu 42988 (KR)
(72) Inventor: KIM, Seung Hoon, Dalseong-gun Daegu 43016 (KR); KIM, Jong Man, Dalseong-gun Daegu 42995 (KR); LEE, Jung Min, Dalseong-gun Daegu 43016 (KR)
(74) Representative: Bjerkén Hynell KB
(86) International application number: PCT/KR2023/000343
(87) International publication number: WO 2023/132711

(57) **Abstract**

A target material separation control device using a laser diode includes a plurality of chambers and a channel connecting the plurality of chambers to each other, a separation disk configured to separate a target material from a sample by centrifugal force generated by rotation, a printed circuit board assembly detachably coupled to the separation disk and including the laser diode that opens and closes the valve in the channel by emitting laser to the valve to generate heat, and a coupling portion provided to penetrate the printed circuit board assembly and fixing a printed circuit board to the separation disk.

## Description

### [Technical Field]

The present invention relates to a target material separation control device using a laser diode, and more particularly, to a target material separation control device using a laser diode that enables accurate and smooth opening and closing of a valve by using a laser diode to increase the wax temperature of the valve provided in a channel connecting chambers of a separation disk.

### [Background Art]

Most deaths associated with malignant tumors are due to metastasis to tissues and organs distant from a site of initial tumor origin. Therefore, early detection of metastasis is an important determinant of the survival probability of cancer patients.

Early detection of tumors and monitoring of tumor growth are considered to be very important factors in the successful treatment of cancer patients.

Diagnosis of cancer generally uses diagnostic techniques based on histopathology. Histopathological diagnostic techniques are techniques for diagnosing tumors by using tissue samples obtained from biopsies. The histopathological approach allows tumor cells to be directly observed.

Meanwhile, circulating tumor cells (CTCs) are known to be discovered in patients before tumor is first detected. Therefore, circulating tumor cells may play an important role in early diagnosis and prediction of cancer. Since cancer generally spreads through the blood, circulating tumor cells may be a marker for diagnosing whether cancer is metastasized.

To this end, a disk-type device that extracts target cells such as circulating tumor cells from samples such as blood is being researched and developed.

A conventional disk device includes, for example, a disk including a plurality of chambers, rotates the disk to generate centrifugal force, and separates target cells, such as circulating tumor cells, from the blood by using the centrifugal force.

The plurality of chambers may roughly include a main chamber and a separation chamber connected to the main chamber through a channel, and a valve is provided in the channel such that a material may be moved by opening and closing the valve.

However, in the conventional disk device, the valve is generally made of wax or so on which reacts with heat, but the heat is not properly transmitted to the valve, and thus, there is a risk that an error may occur in an operation of the valve.

Accordingly, there is a need for the development of a new cell separation control device that operates the valve accurately to accurately and smoothly perform the separation of target cells.

The present invention is the result of a development project of inertial centrifugal microfluidic technology for separation of fetal cells from pregnant woman's blood for manufacturing and operating performance of mass production-based target cell separation device and non-invasive early prenatal confirmation test.

### [Disclosure]

### [Technical Problem]

An embodiment of the present invention provides a target material separation control device using a laser diode that enables accurate and smooth opening and closing of a valve by using a laser diode to increase the wax temperature of the valve provided in a channel connecting chambers of a separation disk.

A problem to be solved by the present invention is not limited to the problem described above, and other problem(s) not described above will be clearly understood by those skilled in the art from the description below.

### [Technical Solution]

A target material separation control device using a laser diode according to an embodiment of the present invention includes a plurality of chambers and a channel connecting the plurality of chambers to each other, a separation disk configured to separate a target material from a sample by centrifugal force generated by rotation, a printed circuit board assembly detachably coupled to the separation disk and including the laser diode that opens and closes the valve in the channel by emitting laser to the valve to generate heat, and a coupling portion provided to penetrate the printed circuit board assembly and fixing a printed circuit board to the separation disk.

According to one aspect, the printed circuit board assembly may include a first circuit board for control and a second circuit board on which the laser diode is mounted.

According to one aspect, the printed circuit board assembly may further include a connection portion provided between the first circuit board and the second circuit board and determining a position and an angle of the second circuit board with respect to the separation disk.

According to one aspect, an upper surface of the separation disk may have a shape that inclines downward from the center to the outside, the connection portion may have a shape that inclines downward from the center to a lower portion to correspond to an inclination angle of the upper surface of the separation disk, and the second circuit board may be coupled to a lower surface of the connection portion.

According to one aspect, a total of four sets of the plurality of chambers connected to the channel may be provided in a circumferential direction of the separation disk, four second circuit boards may be provided, and when the printed circuit board assembly is coupled to the separation disk by the coupling portion, positions of the four second circuit boards and four sets of the plurality of chambers may be aligned to each other, and a position of the laser diode of the second circuit board and a position of the valve in the channel may match each other.

According to one aspect, the coupling portion may include a penetration member configured to penetrate the center of the printed circuit board assembly to be inserted into a coupling hole formed in the center of the separation disk, and a rotation member provided at an upper end portion of the penetration member, pressurizing the penetration member to be inserted into the coupling hole to rotate the penetration member to fix the penetration member to the coupling hole and to couple the printed circuit board assembly to the separation disk.

According to one aspect, straight holes may be formed at 180-degree intervals in the coupling hole formed in the separation disk, and straight protrusions, each corresponding to a shape of the coupling hole, may be provided at 180-degree intervals, and when the penetration member is inserted into the coupling hole and is rotated, the straight protrusions of the penetration member may be caught and fixed to a lower end of the coupling hole.

According to one aspect, the coupling portion further may include an elastic member located between the rotation member and an upper surface of the printed circuit board assembly through which the penetration member penetrates and inserted into the penetration member to generate force that pushes the rotation member against the printed circuit board assembly to strengthen a coupling force of the printed circuit board assembly to the separation disk.

According to one aspect, the printed circuit board assembly may further include a communication unit provided on the first circuit board and configured to control an operation of the laser diode mounted on the second circuit board through wireless communication with an external device.

According to one aspect, laser in a range of 750 to 890 nm may be emitted from the laser diode to melt the valve made of a thermoplastic resin or a phase change material.

### [Advantageous Effects]

According to an embodiment of the present invention, opening and closing operations of a valve may be performed accurately and smoothly by increasing a wax temperature of the valve included in a channel connecting chambers of the separation disk by using the laser diode.

In addition, according to an embodiment of the present invention, a printed circuit board assembly may be quickly and accurately coupled to a separation disk by a coupling portion, and therethrough, a position of a laser diode and a position of a valve may be accurately aligned to each other.

In addition, according to the embodiment of the present invention, compared to a laser-controlled opening and closing method using rotation performed in synchronization with the existing disk, a valve of the present invention may be fully opened and closed through wireless communication without being limited by a rotation speed and direction, and thus, the performance of a target material separation and control device may be effectively increased.

### [Description of Drawings]

FIG. 1 is a front view of a target material separation control device using a laser diode according to an embodiment of the present invention.
FIG. 2 is an exploded perspective view of FIG. 1.
FIG. 3 is a perspective view of a separation disk of FIG. 1.
FIG. 4 is a view of a printed circuit board assembly illustrated in FIG. 1, which is viewed from below.
FIG. 5 is a modified view of FIG. 1 and illustrates another structure of a separation disk and a printed circuit board assembly coupled thereto.
FIG. 6 is a view illustrating a printed circuit board assembly being coupled to a separation disk by a coupling portion illustrated in FIG. 1.
FIG. 7 illustrates sequential views of a structure including a penetration member of a coupling portion caught inside a coupling hole, which is an internal structure of the coupling hole illustrated in FIG. 6.

### [Mode for Invention]

The advantages and/or characteristics of the present invention and methods for achieving the advantages and/or characteristics will be apparent by referring to embodiments described in detail below in conjunction with the accompanying drawings. However, the present invention is not limited to the embodiments disclosed below and will be implemented in various different forms, and the embodiments are provided only to ensure that the disclosure of the present invention is complete and to fully inform those skilled in the art of the scope of the invention, and the present invention is only defined by the scope of the claims. Like reference numerals refer to like components throughout the specification.

Hereinafter, embodiments of the present invention will be described in detail with reference to the attached drawings.

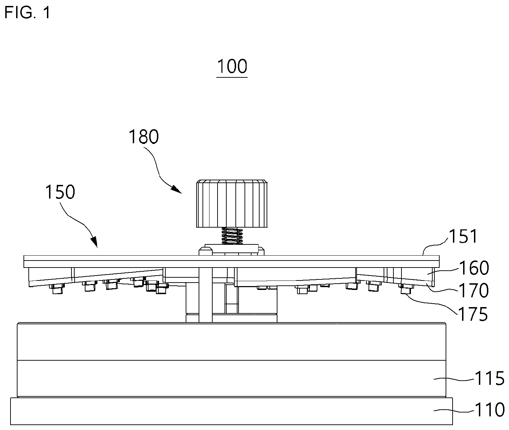

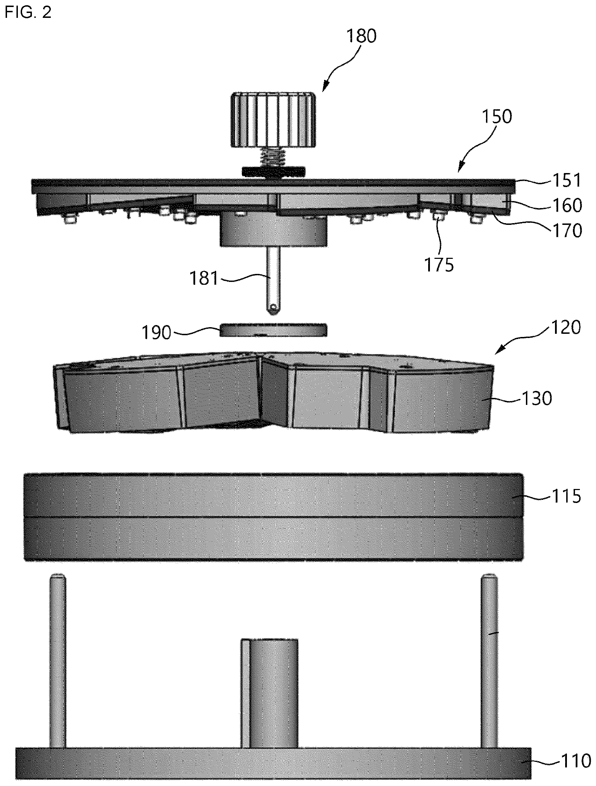

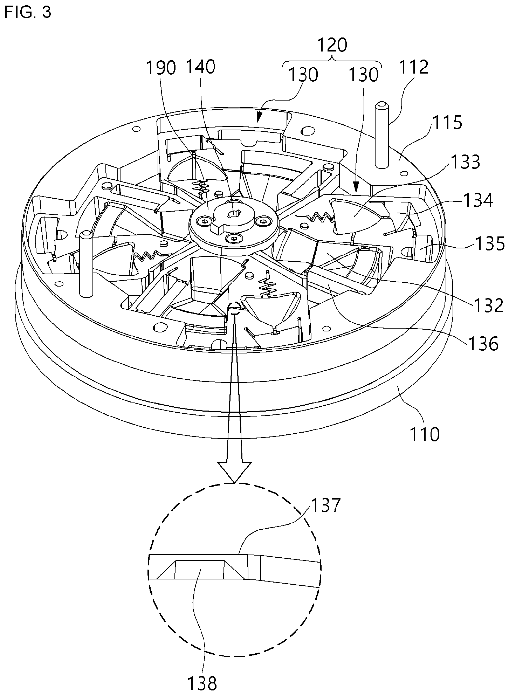

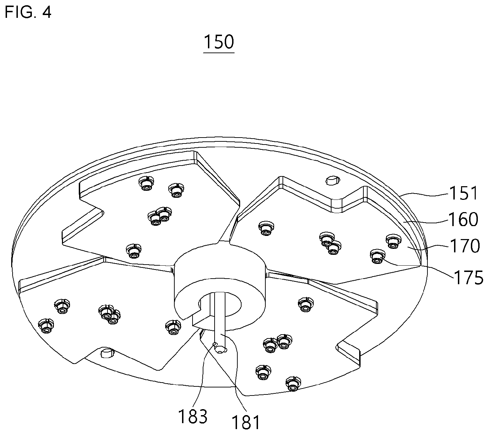

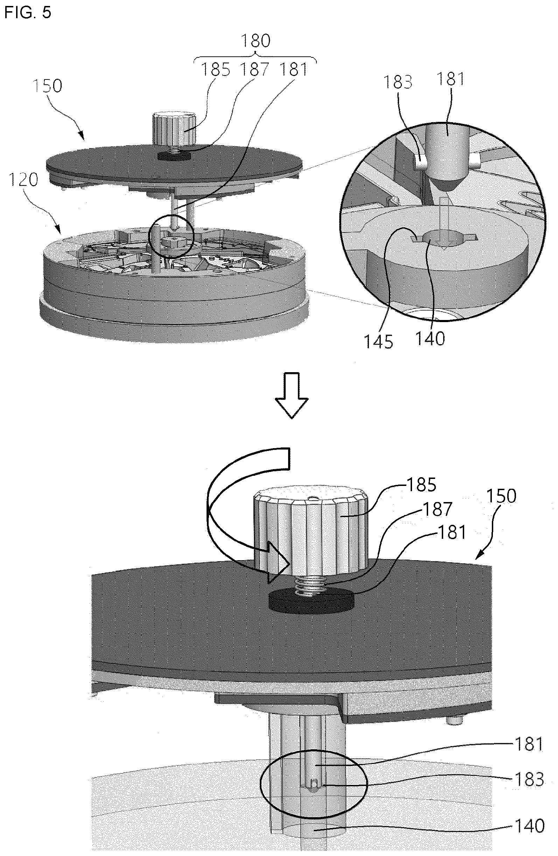

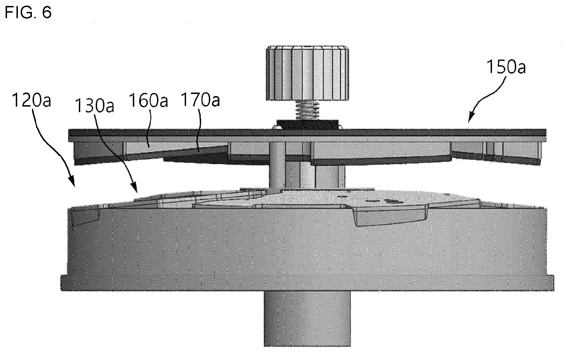

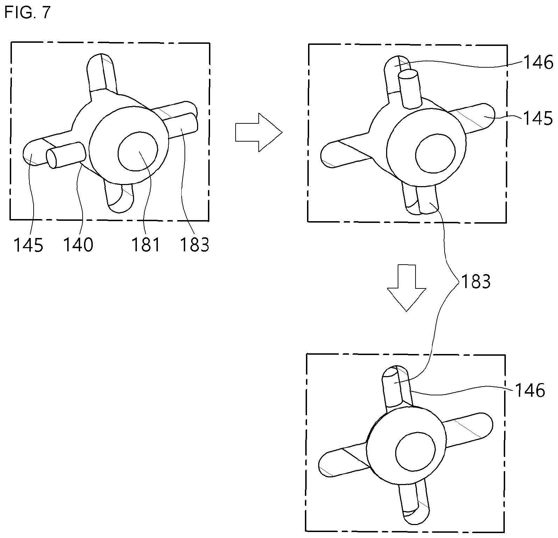

FIG. 1 is a front view of a target material separation control device using a laser diode according to an embodiment of the present invention, FIG. 2 is an exploded perspective view of FIG. 1, FIG. 3 is a perspective view of a separation disk of FIG. 1, FIG. 4 is a view of a printed circuit board assembly illustrated in FIG. 1, which is viewed from below, FIG. 5 is a modified view of FIG. 1 and illustrates another structure of a separation disk and a printed circuit board assembly coupled thereto, FIG. 6 is a view illustrating a printed circuit board assembly being coupled to a separation disk by a coupling portion illustrated in FIG. 1, and FIG. 7 illustrates sequential views of a structure including a penetration member of a coupling portion caught inside a coupling hole, which is an internal structure of the coupling hole illustrated in FIG. 6.

As illustrated in the drawings, particularly referring to FIGS. 1 and 2, a target material separation control device 100 using a laser diode according to an embodiment of the present invention may include a separation disk 120, a disk rack 115 having an internal part coupled to the separation disk 120, a disk fixing portion 190 for fixing the separation disk 120, a printed circuit board assembly 150 coupled to the separation disk 120, a coupling portion 180 that couples the printed circuit board assembly 150 to the separation disk 120, and a rotor 110 including a fixing pin 112 fixed to the disk rack 115 and including a motor (not illustrated) that generates a rotational force.

Referring to each configuration, the separation disk 120 of the present embodiment rotates with the rotation of the rotor 110 by a motor that generates a drive force for rotation, as illustrated in FIGS. 1 and 2, and the generated centrifugal force may be used to separate a target material from a sample, for example, a target cell from blood.

In addition to this, the rotor 110 may be coupled to the disk rack 115 into which the separation disk 120 is inserted by a fixing pin 112, and the separation disk 120 coupled by rotation of the rotor 110 may be rotated together.

Here, a rotation speed of the rotor 110 or so on may be determined under the control by a control unit, and a centrifugal force is generated in proportion to the rotation speed, and accordingly, target cells may be smoothly separated from the blood in the separation disk 120 by the centrifugal force.

In the present embodiment, a case in which a target material, for example, a target cell, such as a circulating tumor cell, is separated from a sample, that is, blood, through an operation of the separation disk 120 is described in detail, but the present embodiment is not limited thereto, and particles or cells included in a biological sample may be separated by using the target material separation control device 100 of the present embodiment, and for example, the cells may be circulating tumor cells (CTCs).

The separation disk 120 of the present embodiment may include a plurality of unit chamber sets 130 including a plurality of chambers 132, 133, 134, 135, and 136 that are inserted into and coupled to the disk rack 115 and provided in a groove shape, as illustrated in FIGS. 2 and 3. With this configuration, by using the centrifugal force generated when the separation disk 120 coupled to the disk rack 115 rotates according to the rotation of the rotor 110, circulating tumor cells, which are targets cells, may be separated from blood in each unit chamber set 130.

Referring to FIG. 3, a total of four unit chamber sets 130 of the present embodiment are provided and may be arranged at 90-degree intervals in the disk rack 115 in a circumferential direction. In addition, as is described below, a part of a structure of the printed circuit board assembly 150 corresponds thereto, and thus, the circulating tumor cells may be smoothly separated in each unit chamber set 130.

As described above, each unit chamber set 130 includes the plurality of chambers 132, 133, 134, 135, and 136, and each of which includes a main chamber 132, a plasma separation chamber 136, a mixing chamber 133, a separation chamber 134, a target cell accommodation chamber 135, and so on as illustrated in FIG. 3.

Through the chamber structure, for example, circulating tumor cells may be separated from the blood, and in order for the process to be performed smoothly, it is essential that a valve 138 of a channel 137 connecting the chambers 132, 133, 134, 135, and 136 to each other operates smoothly.

In addition to this, the channel 137 connecting one chamber 132, 133, 134, 135, or 136 to the other chamber 132, 133, 134, 135, or 136 adjacent thereto, more specifically, for example, the channel 137 connecting the main chamber 132 to the mixing chamber 133 is equipped with a valve 138 that is opened and closed by the heat provided from the outside, and in the present embodiment, by accurately controlling the heat for opening and closing the valve 138, a separated material may be moved through the channel 137 connecting the chambers.

That is, it is necessary to accurately open and close the valve 138 by precisely emitting the laser to a position of the valve 138 of the channel 137 to generate heat, and to this end, the present embodiment may precisely control the opening and closing of each valve 138 through the printed circuit board assembly 150 that is integrated with the separation disk 120 and is provided such that the position of the valve 138 and a laser diode 175 may be accurately aligned.

First, the valve 138 provided in the channel 137 of the present embodiment is described. The valve 138 of the present embodiment may be a thermoplastic resin or a phase change material that remains solid when blocking a path of the channel 137 and melts when heat is applied through the laser diode 175.

In the present embodiment, the valve 138 may be made of wax as a phase change material. The wax may include any one of paraffin wax, microcrystalline wax, petrolatum wax, animal or vegetable synthetic wax, and natural wax. However, the present embodiment is not limited thereto.

Meanwhile, a thermoplastic resin may be applied to the valve 138, and the thermoplastic resin may include COC (cyclic olefin copolymer), PMMA (polymethylmethacrylate), PC (polycarbonate), PS (polystyrene), POM (polyoxymethylene), PFA (perfluoralkoxy), PVC (polyvinylchloride), PP (polypropylene), PET (polyethylene terephthalate), PEEK (polyetheretherketone), PA (polyamide), PSU (polysulfone), PVDF (polyvinylidene fluoride), or so on.

Meanwhile, the printed circuit board assembly 150 of the present embodiment is coupled to the separation disk 120 as illustrated in FIGS. 1 to 4, and the valve 138 may be opened and closed by providing the laser diode 175 to correspond to each position of the valve 138 in the channel 137 of the separation disk 120.

In addition to this, a plurality of laser diodes 175 are provided on a lower surface of the printed circuit board assembly 150 to correspond to a position of the valve 138 of the channel 137, and therethrough, by emitting laser from the laser diode 175 to the valve 138 made of wax, heat may be generated to open the valve 138, and in addition, by stopping heat generation, the valve 138 may be solidified and the channel 137 may be blocked.

To this end, the printed circuit board assembly 150 has a structure optimized for transferring heat to the valve 138 through the laser diode 175, and a configuration thereof is as follows.

As illustrated in FIGS. 1 to 4, the printed circuit board assembly 150 of the present embodiment may include a first circuit board 151 for control, a connection portion 160 coupled to a lower portion of the first circuit board 151, and a second circuit board 170 coupled to a lower end portion of the connection portion 160 and on which the laser diodes 175 are mounted.

First, the first circuit board 151 of the present embodiment has a circular plate shape corresponding to a shape of the separation disk 120 as illustrated in FIG. 3, and a plurality of components for control are installed thereon.

For example, the first circuit board 151 may include a communication unit (not illustrated) for controlling operations of the laser diodes 175 mounted on the second circuit board 170 through wireless communication with an external device. For example, a command signal for operating the laser diode 175 may be input to the communication unit from the external device, and a control unit included in the first circuit board 151 may operate the laser diodes 175 based on the command signal received by the communication unit to control opening and closing of the valve 138 in the channel 137.

In addition, for example, a rotation speed, a rotation direction, and so on of the rotor, in addition to drives of the laser diodes 175, may be controlled by mutual operations of the communication unit and the control unit.

Meanwhile, the connection portion 160 of the present embodiment may be coupled to a lower end portion of the first circuit board 151 as illustrated in FIGS. 1 and 4 and may determine the position and inclination angle of the second circuit board 170 which is described below.

As described above, the separation disk 120 of the present embodiment includes a total of four unit chamber sets 130 including the plurality of chambers 132, 133, 134, 135, and 136 arranged at 90-degree intervals, and referring to FIG. 4, a total of four connection portions 160 of the present embodiment may be provided to correspond to positions of respective unit chamber sets 130.

In addition to this, as illustrated in FIGS. 1 to 3, an upper surface of the separation disk 120 may be flat, and on the other hand, as illustrated in FIG. 5, the separation disk 120a may have a shape that inclines downward from the center to the outside. Hereinafter, shapes and a coupling structure of the separation disk 120a and the printed circuit board assembly 150a will be described with reference to FIG. 4.

FIG. 5 is a modified view of FIG. 1 and illustrates another structure of a separation disk and a printed circuit board assembly coupled thereto.

As illustrated here, in order to more securely separate a target material from each unit chamber set 130a of the separation disk 120a, the separation disk 120a may have a shape that inclines downward from the center to the outside, and a connection portion 160a may also have a shape that inclines downward from the center to a lower portion to correspond thereto, and accordingly, a position and inclination angle of a second circuit board 170a coupled to a lower surface of the connecting portion 160a may also correspond to the inclined shape of the separation disk 120a.

Therefore, when the printed circuit board assembly 150a is coupled to the separation disk 120a, the second circuit board 170a each being coupled to divided connection portions 160a may tightly cover the corresponding unit chamber set 130a, and in this case, the laser diode 175 (see FIG. 1) mounted on the second circuit board 170a is accurately located at a position of the valve 138 in the channel 137, and thereby, heat may be accurately provided from the laser diode 175 to the valve 138.

In addition to this, a size of a laser wavelength emitted from the laser diode 175 may range from 750 nm to 890 nm, and the energy output therethrough may range from 0.7 to 2.5 W.

However, even when the laser is emitted from the laser diode 175 and heat of the laser is not transferred properly, the valve 138 may not be opened and closed properly, and accordingly, it is important that the printed circuit board assembly 150 is accurately coupled to the separation disk 120 to ensure accurate contact between the laser diode 175 and the valve 138 to ensure proper heat transfer, and for this purpose, the present embodiment further includes a coupling portion 180.

As illustrated in FIGS. 6 and 7, the coupling portion 180 of the present embodiment has a structure that penetrates the printed circuit board assembly 150 and is partially coupled to the disk rack 115, and therethrough, coupling and disengagement between the printed circuit board assembly 150 and the separation disk 120 may be easily achieved.

Referring to FIG. 6, the coupling portion 180 of the present embodiment may include a penetration member 181 that penetrates the center of the printed circuit board assembly 150 to be inserted into a coupling hole 140 provided in the center of the disk rack 115, and a rotation member 185 that is provided at an upper end portion of the penetration member 181, pressurizes the penetration member 181 to be inserted into the coupling hole 140 to rotate the penetration member 181 to fix the penetration member 181 to the coupling hole 140, thereby firmly coupling the printed circuit board assembly 150 to the separation disk 120.

Referring to FIG. 7, the inside of the coupling hole 140 is provided with a straight fixing groove 146 in a direction perpendicular to the straight hole 145, and after a straight protrusion 183 of the penetration member 181 penetrates the straight hole 145 and the penetration member 181 turns 90 degrees, and when the pressure on the penetration member 181 is released, the straight protrusion 183 may be fixed to the fixing groove 146 provided in the coupling hole 140.

As illustrated in FIG. 7, the coupling hole 140 formed in the center of the disk rack 115 may be provided with straight holes 145 spaced at 180 degree intervals.

In addition, straight protrusions 183 may be provided at 180-degree intervals at a lower end portion of the penetration member 181 to correspond to a shape of the coupling hole 140. With this configuration, when the penetration member 181 is inserted into the coupling hole 140 and is rotated, the straight protrusion 183 of the penetration member 181 may be caught at a lower end of the coupling hole 140 to be fixed thereto, and based on this principle, the printed circuit board assembly 150 may be fixed to the disk rack 115 through the coupling portion 180.

Meanwhile, the coupling portion 180 of the present embodiment may further include an elastic member 187 to strengthen the coupling between the printed circuit board assembly 150 and the separation disk 120. As illustrated in FIG. 6, the elastic member 187 of the present embodiment may be located between the rotation member 185 and an upper surface of the printed circuit board assembly 150 through which the penetration member 181 penetrates and may be inserted into the rotation member 185 to generate the force that pushes the rotation member 185 upward, and therethrough, an effect of pressurizing the printed circuit board assembly 150 in a direction of the separation disk 120 is obtained, and thereby, the bonding force between the separation disk 120 and the printed circuit board assembly 150 may be strengthened.

In addition to this, when the coupling of the printed circuit board assembly 150 to the separation disk 120 is completed by using the coupling portion 180, a position of the laser diode 175 of the second circuit board 170 matches a position of the valve 138 provided in the channel 137 connecting the chambers 132, 133, 134, 135, and 136 to each other, and therethrough, heat may be accurately transferred from the laser diode 175 to the valve 138, and thereby, opening and closing of the channel 137 using the valve 138 may be accurately performed.

However, the coupling of the printed circuit board assembly 150 to the separation disk 120 using the coupling portion 180 is not limited thereto, and it is natural that, for example, a screw coupling method, a fitting coupling method, a coupling method using a magnetic material, or so on may be applied.

As such, according to the embodiment of the present invention, opening and closing operations of the valve 138 may be performed accurately and smoothly by increasing a wax temperature of the valve 138 included in the channel 137 of the separation disk 120 by using the laser diode 175.

In addition, the printed circuit board assembly 150 may be quickly and accurately coupled to the separation disk 120 by the coupling portion 180, and therethrough, a position of the laser diode 175 and a position of the valve 138 may be accurately aligned to each other.

In addition, compared to a laser-controlled opening and closing method using rotation performed in synchronization with the existing disk, the valve of the present invention may be fully opened and closed through wireless communication without being limited by a rotation speed and direction, and thus, the performance of a target material separation and control device may be effectively increased.

Although specific embodiments according to the present invention are described above, it goes without saying that various modifications may be made without departing from the scope of the present invention. Therefore, the scope of the present invention should not be limited to the described embodiments but should be determined by the scope of the patent claims described below as well as equivalents to the patent claims.

As described above, although the present invention is described with reference to limited embodiments and drawings, the present invention is not limited to the above-described embodiments, and those skilled in the art to which the present invention pertains may make various modifications and changes from the descriptions. Accordingly, the idea of the present invention should be understood only by the scope of the claims set forth below, and all equivalent or equivalent modifications thereof shall fall within the scope of the idea of the present invention.

## Claims

1. A target material separation control device using a laser diode, comprising:
a plurality of chambers and a channel connecting the plurality of chambers to each other;
a separation disk configured to separate a target material from a sample by centrifugal force generated by rotation;
a printed circuit board assembly detachably coupled to the separation disk and including the laser diode that opens and closes the valve in the channel by emitting laser to the valve to generate heat; and
a coupling portion provided to penetrate the printed circuit board assembly and fixing a printed circuit board to the separation disk.

2. The target material separation control device using the laser diode according to Claim 1, wherein the printed circuit board assembly includes
a first circuit board for control; and
a second circuit board on which the laser diode is mounted.

3. The target material separation control device using the laser diode according to Claim 2, wherein the printed circuit board assembly further includes
a connection portion provided between the first circuit board and the second circuit board and determining a position and an angle of the second circuit board with respect to the separation disk.

4. The target material separation control device using the laser diode according to Claim 3, wherein
an upper surface of the separation disk has a shape that inclines downward from the center to the outside,
the connection portion has a shape that inclines downward from the center to a lower portion to correspond to an inclination angle of the upper surface of the separation disk, and
the second circuit board is coupled to a lower surface of the connection portion.

5. The target material separation control device using the laser diode according to Claim 4, wherein
a total of four sets of the plurality of chambers connected to the channel are provided in a circumferential direction of the separation disk,
four second circuit boards are provided, and
when the printed circuit board assembly is coupled to the separation disk by the coupling portion, positions of the four second circuit boards and four sets of the plurality of chambers are aligned to each other, and a position of the laser diode of the second circuit board and a position of the valve in the channel match each other.

6. The target material separation control device using the laser diode according to Claim 1, wherein the coupling portion includes
a penetration member configured to penetrate the center of the printed circuit board assembly to be inserted into a coupling hole formed in the center of the separation disk; and
a rotation member provided at an upper end portion of the penetration member, pressurizing the penetration member to be inserted into the coupling hole to rotate the penetration member to fix the penetration member to the coupling hole and to couple the printed circuit board assembly to the separation disk.

7. The target material separation control device using the laser diode according to Claim 6, wherein
straight holes are formed at 180-degree intervals in the coupling hole formed in the separation disk, and straight protrusions, each corresponding to a shape of the coupling hole, are provided at 180-degree intervals and are formed in a lower end of the penetration member, and
when the penetration member is inserted into the coupling hole and is rotated, the straight protrusions of the penetration member are caught and fixed to a lower end of the coupling hole.

8. The target material separation control device using the laser diode according to Claim 6, wherein the coupling portion further includes
an elastic member located between the rotation member and an upper surface of the printed circuit board assembly through which the penetration member penetrates and inserted into the penetration member to generate force that pushes the rotation member against the printed circuit board assembly to strengthen a coupling force of the printed circuit board assembly to the separation disk.

9. The target material separation control device using the laser diode according to Claim 2, wherein the printed circuit board assembly further includes
a communication unit provided on the first circuit board and configured to control an operation of the laser diode mounted on the second circuit board through wireless communication with an external device.

10. The target material separation control device using the laser diode according to Claim 1, wherein
laser in a range of 750 to 890 nm is emitted from the laser diode to melt the valve made of a thermoplastic resin or a phase change material.
